# EUROPEAN PATENT APPLICATION

(11) **EP 4 629 285 A1**
(43) Date of publication of application: **08.10.2025**
(21) Application number: 25159619.3
(22) Date of filing: 24.02.2025
(51) Int. Cl.: H01L 21/768, H01L 23/522, H01L 23/532

(54) **SEMICONDUCTOR DEVICE**

(30) Priority: 05.04.2024 KR 20240046599
(71) Applicant: Samsung Electronics Co., Ltd., Suwon-si, Gyeonggi-do 16677 (KR)
(72) Inventor: LEE, Eui Bok, 16677 Suwon-si (KR); KIM, Na Hyang, 16677 Suwon-si (KR); KIM, Rak Hwan, 16677 Suwon-si (KR); LIM, Seung Min, 16677 Suwon-si (KR)
(74) Representative: Marks & Clerk LLP

(57) **Abstract**

A semiconductor device includes a substrate, a first interlayer insulating layer, a lower wiring layer, a lower wiring capping layer, an etching stop layer, a second interlayer insulating layer, a via trench that extends into the etching stop layer and the second interlayer insulating layer in a first direction, and a via in the via trench, where the via is in contact with the upper surface of the lower wiring capping layer, where an upper surface of the via in the first direction relative to the upper surface of the substrate is higher than an upper surface of the second interlayer insulating layer in the first direction relative to the upper surface of the substrate, and where the lower wiring capping layer includes a same material as the via.

## Description

### TECHNICAL FIELD

The present invention relates to a semiconductor device.

### BACKGROUND

Due to the development of electronic technology, the down-scaling of semiconductor devices has been progressing rapidly in recent years, and there is a demand for higher integration and lower power consumption of semiconductor chips. As the spacing between circuit components such as wiring is gradually decreasing, there is a growing issue of increased resistance between the wiring and vias. Research is being conducted to address problems such as increasing resistance between wiring and vias, for example to improve the reliability of semiconductor devices.

### SUMMARY

According to an aspect of the present invention, there is provided a semiconductor device according to claim 1. Preferred embodiments are defined by the dependent claims.

The present disclosure describes a semiconductor device that, in some implementations, may improve the electrical reliability of the lower wiring layer by forming the material of the lower wiring capping layer and the material of the via to be the same.

The aspects of the present disclosure is not limited to those mentioned above and another aspect which is not mentioned can be clearly understood by those skilled in the art from the description below. The invention is defined by the claims.

According to some embodiments of the present disclosure, there is provided a semiconductor device, comprising a substrate, a first interlayer insulating layer on an upper surface of the substrate, a lower wiring layer in the first interlayer insulating layer, a lower wiring capping layer on an upper surface of the lower wiring layer, an etching stop layer on each of an upper surface of the first interlayer insulating layer and an upper surface of the lower wiring capping layer, where the etching stop layer is in contact with the upper surface of the lower wiring capping layer, a second interlayer insulating layer on an upper surface of the etching stop layer, a via trench that extends into the etching stop layer and the second interlayer insulating layer in a first direction that is perpendicular to the upper surface of the substrate, where the via trench extends to the upper surface of the lower wiring capping layer, and a via in the via trench, where the via is in contact with the upper surface of the lower wiring capping layer, where an upper surface of the via in the first direction relative to the upper surface of the substrate is higher than an upper surface of the second interlayer insulating layer in the first direction relative to the upper surface of the substrate, and where the lower wiring capping layer includes a same material as the via.

According to some embodiments of the present disclosure, there is provided a semiconductor device, comprising a substrate, a first interlayer insulating layer on an upper surface of the substrate, a lower wiring layer in the first interlayer insulating layer, a lower wiring capping layer on an upper surface of the lower wiring layer, a second interlayer insulating layer on each of an upper surface of the first interlayer insulating layer and an upper surface of the lower wiring capping layer, a via trench that extends into the second interlayer insulating layer in a first direction that is perpendicular to the upper surface of the substrate, where the via trench extends to the upper surface of the lower wiring capping layer, a via in the via trench, where the via is in contact with the upper surface of the lower wiring capping layer, where an upper surface of the via in the first direction relative to the upper surface of the substrate is higher than an upper surface of the second interlayer insulating layer in the first direction relative to the upper surface of the substrate, a third interlayer insulating layer on the upper surface of the second interlayer insulating layer, an upper wiring trench that is in the third interlayer insulating layer and is on the upper surface of the via, and an upper wiring layer in contact with the upper surface of the via, where the upper wiring layer includes an upper wiring barrier layer on at least a portion of a lower surface of the upper wiring trench and a sidewall of the upper wiring trench, where the upper wiring layer includes an upper wiring filling layer on the upper wiring barrier layer, where the lower wiring capping layer includes a same material as the via.

According to some embodiments of the present disclosure, there is provided a semiconductor device, comprising a substrate, a first interlayer insulating layer on an upper surface of the substrate, a lower wiring layer in the first interlayer insulating layer, a lower wiring capping layer on an upper surface of the lower wiring layer, where an upper surface of the lower wiring capping layer in a first direction relative to the upper surface of the substrate is higher than an upper surface of the first interlayer insulating layer in the first direction relative to the upper surface of the substrate, where the first direction is perpendicular to the upper surface of the substrate, an etching stop layer on each of the upper surface of the first interlayer insulating layer and the upper surface of the lower wiring capping layer, where the etching stop layer is in contact with a sidewall of the lower wiring capping layer and the upper surface of the lower wiring capping layer, a second interlayer insulating layer on an upper surface of the etching stop layer, a via trench that extends into the etching stop layer and the second interlayer insulating layer in the first direction, where the via trench extends to the upper surface of the lower wiring capping layer, a via in the via trench, where the via is in contact with the upper surface of the lower wiring capping layer, where an upper surface of the via in the first direction relative to the upper surface of the substrate is higher than an upper surface of the second interlayer insulating layer in the first direction relative to the upper surface of the substrate, where the via includes a single layer, where a sidewall of the via is in contact with each of the etching stop layer and the second interlayer insulating layer, a third interlayer insulating layer on the upper surface of the second interlayer insulating layer, an upper wiring trench that is in the third interlayer insulating layer and is on the upper surface of the via, and an upper wiring layer that is in contact with the upper surface of the via, where the upper wiring layer includes an upper wiring barrier layer on at least a portion of a lower surface of the upper wiring trench and a sidewall of the upper wiring trench, where the upper wiring layer includes an upper wiring filling layer on the upper wiring barrier layer, where the upper surface of the via is in contact with the upper wiring filling layer, where the lower wiring capping layer includes a same material as the via throughout, and where a width of the lower wiring capping layer in a second direction that is parallel to the upper surface of the substrate is equal to a width of the upper surface of the lower wiring layer in the second direction.

### BRIEF DESCRIPTION OF THE DRAWINGS

The above and other aspects and features of the present disclosure will become more apparent by describing in detail exemplary embodiments thereof with reference to the attached drawings, in which:
FIG. 1 is a diagram for explaining a semiconductor device according to some embodiments of the present disclosure;
FIG. 2 is an enlarged view of region R1 of FIG. 1;
FIGS. 3 to 9 are intermediate stage diagrams for explaining a method of fabricating semiconductor devices according to some embodiments of the present disclosure;
FIG. 10 is a diagram for explaining a semiconductor device according to some other embodiments of the present disclosure;
FIG. 11 is an enlarged view of region R2 of FIG. 10;
FIG. 12 is a diagram for explaining a semiconductor device according to embodiments of the present disclosure;
FIG. 13 is an enlarged view of region R3 of FIG. 12;
FIG. 14 is a diagram for explaining a semiconductor device according to embodiments of the present disclosure;
FIG. 15 is a diagram for explaining a semiconductor device according to embodiments of the present disclosure;
FIG. 16 is a drawing for explaining a semiconductor device according to embodiments of the present disclosure;
FIG. 17 is a drawing for explaining a semiconductor device according to embodiments of the present disclosure; and
FIG. 18 is a diagram for explaining a semiconductor device according to embodiments of the present disclosure.

### DETAILED DESCRIPTION

To clarify the present disclosure, the same elements or equivalents are referred to by the same reference numerals throughout the specification. Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, thicknesses of some layers and areas are excessively displayed.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

In addition, unless explicitly described to the contrary, the word "comprises", and variations such as "comprises" or "comprising", will be understood to imply the inclusion of stated elements but not the exclusion of any other elements. As used herein, the singular forms "a," "an" and "the" are intended to include the plural forms as well, unless the context clearly indicates otherwise. The term "and/or" includes any and all combinations of one or more of the associated listed items. The term "connected" may be used herein to refer to a physical and/or electrical connection and may refer to a direct (i.e., no intervening elements are present) or indirect physical and/or electrical connection.

Further, in the specification and claims, terms including ordinal numbers such as "first," "second," etc. may be used to distinguish between components or elements. These ordinal numbers are used to distinguish identical or similar components from each other, and the meaning of the terms should not be interpreted as having a limited order of use or arrangement based on the number.

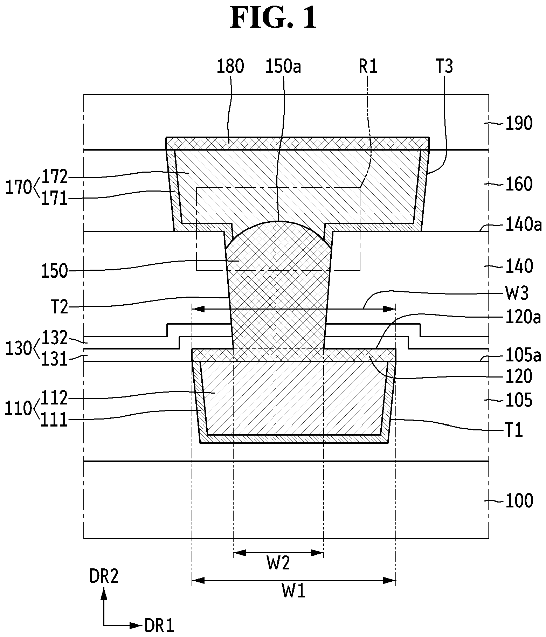

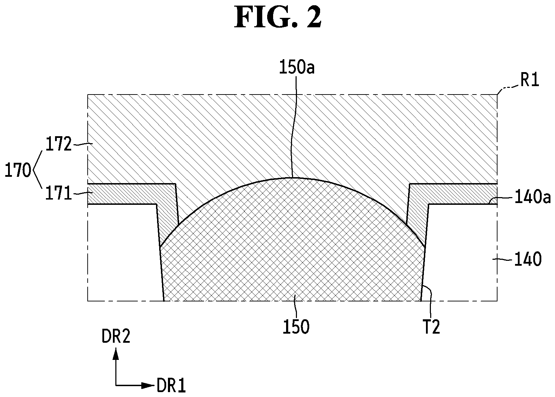

Hereinafter, a semiconductor device according to some embodiments of the present disclosure will be described with reference to FIGS. 1 and 2.

FIG. 1 is a diagram for explaining a semiconductor device according to some embodiments of the present disclosure. FIG. 2 is an enlarged view of region R1 of FIG. 1.

Referring to FIG. 1 and FIG. 2, a semiconductor device according to some embodiments of the present disclosure include a substrate 100, a first interlayer insulating layer 105, a lower wiring layer 110, a lower wiring capping layer 120, an etching stop layer 130, a second interlayer insulating layer 140, a via 150, and may comprise a third interlayer insulating layer 160, an upper wiring layer 170, an upper wiring capping layer 180, and/or a fourth interlayer insulating layer 190.

The substrate 100 may be a structure in which a base substrate and an epitaxial layer are stacked, but the present disclosure is not limited thereto. The substrate 100 may be a silicon substrate, a gallium arsenide substrate, a silicon germanium substrate, a ceramic substrate, a quartz substrate, or a glass substrate for displays, or the like, and may be a SOI (Silicon On Insulator) substrate. Additionally or alternatively, although not shown, the substrate 100 may include a conductive pattern. The conductive pattern may be metal wiring or a contact, a gate electrode of a transistor, a source/drain of a transistor, or a diode, but the present disclosure is not limited thereto.

Hereinafter, the horizontal direction DR1 may be defined as a direction parallel to the upper surface of the substrate 100. The vertical direction DR2 may be defined as a direction perpendicular to the horizontal direction DR1. That is, the vertical direction DR2 may be defined as a direction perpendicular to the upper surface of the substrate 100. (The terms 'vertical' and 'horizontal' do not imply any particular orientation of the device).

The first interlayer insulating layer 105 may be disposed on the upper surface of the substrate 100. The first interlayer insulating layer 105 may include for example, at least one of silicon oxide (SiO2), silicon nitride (SiN), silicon oxynitride (SiON), and/or a low-k constant material. The low-k material may include, for example, Tetraethyl orthosilicate (TEOS), Fluorinated TetraEthylOrthoSilicate (FTEOS), Hydrogen SilsesQuioxane (HSQ), Bis-benzoCycloButene (BCB), TetraMethylOrthoSilicate (TMOS), OctaMethylCycloTetraSiloxane (OMCTS), HexaMethylDiSiloxane (HMDS), TriMethylSilyl Borate (TMSB), DiAcetoxyDitertiaryButoxySiloxane (DADBS), TriMethylSilil Phosphate (TMSP), PolyTetraFluoroEthylene (PTFE), Tonen SilaZen (TOSZ ), Fluoride Silicate Glass (FSG), polyimide nanofoams such as polypropylene oxide, Carbon Doped Silicon Oxide (CDO), Organo Silicate Glass (OSG ), SiLK, Amorphous Fluorinated Carbon, silica aerogels, silica xerogels, mesoporous silica, or any combination thereof, but the present disclosure is not limited thereto.

The lower wiring trench T1 may be formed inside the first interlayer insulating layer 105. The lower wiring trench T1 may be formed to recess or extend from the upper surface of the first interlayer insulating layer 105 toward the inside of the first interlayer insulating layer 105. For example, the sidewalls and bottom surface of the lower wiring trench T1 may be defined by the first interlayer insulating layer 105. For example, the width of the lower wiring trench T1 in the horizontal direction DR1 may continuously decrease as it gets closer to the upper surface of the substrate 100.

The lower wiring layer 110 may be disposed inside the lower wiring trench T1. That is, the lower wiring layer 110 may be disposed inside the first interlayer insulating layer 105. For example, the width of the lower wiring layer 110 in the horizontal direction DR1 may continuously decrease as it gets closer to the upper surface of the substrate 100. For example, the upper surface of the lower wiring layer 110 may be exposed on or at the upper surface 105a of the first interlayer insulating layer 105. For example, the upper surface of the lower wiring layer 110 may be formed on the same plane (e.g., coplanar) as the upper surface 105a of the first interlayer insulating layer 105, but the present disclosure is not limited thereto. For example, the lower wiring layer 110 may include a lower wiring barrier layer 111 and a lower wiring filling layer 112.

The lower wiring barrier layer 111 may be disposed along the sidewalls and bottom surface of the lower wiring trench T1. For example, the lower wiring barrier layer 111 may be conformally formed. For example, an uppermost surface of the lower wiring barrier layer 111 may be exposed on the upper surface 105a of the first interlayer insulating layer 105. For example, the uppermost surface of the lower wiring barrier layer 111 may be formed on the same plane as the upper surface 105a of the first interlayer insulating layer 105, but the present disclosure is not limited thereto. The lower wiring barrier layer 111 may include, for example, any one or more of titanium (Ti), titanium nitride (TiN), tantalum (Ta), tantalum nitride (TaN), tantalum carbon nitride (TaCN), tungsten (W), tungsten nitride (WN), WCN), zirconium (Zr), zirconium nitride (ZrN), vanadium (V), vanadium nitride (VN), niobium (Nb), niobium nitride (NbN), or any combination thereof. However, the present disclosure is not limited thereto.

The lower wiring filling layer 112 may be disposed on the lower wiring barrier layer 111 inside the lower wiring trench T1. The lower wiring filling layer 112 may at least partially fill the inside of the lower wiring trench T1 on the lower wiring barrier layer 111. For example, the upper surface of the lower wiring filling layer 112 may be exposed on the upper surface 105a of the first interlayer insulating layer 105. For example, the upper surface of the lower wiring filling layer 112 may be formed on the same plane as the upper surface 105a of the first interlayer insulating layer 105, but the present disclosure is not limited thereto. The lower wiring filling layer 112 may include, for example, at least one of copper (Cu), carbon (C), silver (Ag), cobalt (Co), tantalum (Ta), indium (In), tin (Sn), zinc (Zn), manganese (Mn), titanium (Ti), magnesium (Mg), chromium (Cr), germanium (Ge), strontium (Sr), platinum (Pt), aluminum (Al), zirconium (Zr), tungsten (W), ruthenium (Ru), iridium (Ir), and/or rhodium (Rh). However, the present disclosure is not limited thereto.

The lower wiring capping layer 120 may be disposed on the upper surface of the lower wiring layer 110. The lower wiring capping layer 120 may be in contact with the upper surface of the lower wiring layer 110. For example, the lower wiring capping layer 120 may be in contact with the uppermost surface of the lower wiring barrier layer 111 and the upper surface of the lower wiring filling layer 112. For example, the lower wiring capping layer 120 may protrude or extend in the vertical direction DR2 more than the upper surface 105a of the first interlayer insulating layer 105 relative to the upper surface of the substrate 100. In other words, the upper surface 120a of the lower wiring capping layer 120 may be formed higher in the vertical direction DR2 than the upper surface 105a of the first interlayer insulating layer 105 relative to the upper surface of the substrate 100.

For example, the width W3 of the lower wiring capping layer 120 in the horizontal direction DR1 may be the same as the width W1 of the upper surface of the lower wiring layer 110 in the horizontal direction DR1. In other words, the lower wiring capping layer 120 may be disposed to entirely cover or overlap the upper surface of the lower wiring layer 110 in the vertical direction DR2. For example, the lower wiring capping layer 120 may include the same material throughout. For example, the lower wiring capping layer 120 may include different materials from those of the lower wiring barrier layer 111 and the lower wiring filling layer 112. For example, the lower wiring capping layer 120 may include molybdenum (Mo). In some other embodiments, the lower wiring capping layer 120 may additionally or alternatively include manganese (Mn), ruthenium (Ru), carbon nano tube (CNT), and/or graphene.

The etching stop layer 130 may be disposed on the upper surface 105a of the first interlayer insulating layer 105 and the upper surface 120a of the lower wiring capping layer 120. For example, the etching stop layer 130 may be disposed on the sidewalls of the lower wiring capping layer 120. For example, the etching stop layer 130 may be in contact with at least a portion of the upper surface 120a of the lower wiring capping layer 120. For example, the etching stop layer 130 may be in contact with the upper surface 105a of the first interlayer insulating layer 105 and the sidewalls of the lower wiring capping layer 120. For example, the etching stop layer 130 may be conformally formed.

For example, the etching stop layer 130 may include the first etching stop layer 131 and the second etching stop layer 132. The first etching stop layer 131 may be in contact with the upper surface 105a of the first interlayer insulating layer 105, the upper surface 120a and the sidewalls of the lower wiring capping layer 120. For example, the first etching stop layer 131 may be conformally formed. The second etching stop layer 132 may be disposed on the upper surface of the first etching stop layer 131. The second etching stop layer 132 may be disposed along the surface of the first etching stop layer 131. The second etching stop layer 132 may be in contact with the upper surface of the first etching stop layer 131. For example, the second etching stop layer 132 may be conformally formed.

For example, the first etching stop layer 131 may include aluminum oxide (A12O3) or aluminum nitride (AlN). In some other embodiments, the first etching stop layer 131 may additionally or alternatively include hafnium oxide (Hf2O3) and/or zirconium oxide (Zr2O3). For example, the second etching stop layer 132 may include a different material from the first etching stop layer 131. For example, the second etching stop layer 132 may include any one or more of silicon oxycarbide (SiOC), silicon carbide (SiC), and/or silicon oxide (SiO2).

The second interlayer insulating layer 140 may be disposed on the upper surface of the etching stop layer 130. That is, the second interlayer insulating layer 140 may be disposed on the upper surface of the second etching stop layer 132. The second interlayer insulating layer 140 may be in contact with the upper surface of the second etching stop layer 132. For example, the second interlayer insulating layer 140 may include at least one of silicon oxide (SiO2), silicon nitride (SiN), silicon oxynitride (SiON), and/or a low-k material.

The via trench T2 may penetrate or extend into the etching stop layer 130 and the second interlayer insulating layer 140 in the vertical direction DR2. The via trench T2 may extend to the upper surface 120a of the lower wiring capping layer 120. For example, the bottom surface of the via trench T2 may be defined by the upper surface 120a of the lower wiring capping layer 120. For example, the sidewalls of the via trench T2 may be defined by the etching stop layer 130 and the second interlayer insulating layer 140. For example, the width of the via trench T2 in the horizontal direction DR1 may decrease continuously as it gets closer to the upper surface 120a of the lower wiring capping layer 120.

The via 150 is disposed inside the via trench T2. For example, the lower surface of the via 150 may be in contact with the upper surface 120a of the lower wiring capping layer 120. For example, the sidewalls of the via 150 may be in contact with the etching stop layer 130 and the second interlayer insulating layer 140. For example, the upper surface of the via 150 may be formed to be convex. For example, the uppermost surface 150a of the via 150 may be formed higher than the upper surface 140a of the second interlayer insulating layer 140 relative to the upper surface of the substrate 100. For example, at least a portion of the upper surface of the via 150 may be formed at a lower level in the vertical direction DR2 than the upper surface 140a of the second interlayer insulating layer 140 relative to the upper surface of the substrate 100.

For example, the width of the via 150 in the horizontal direction DR1 may decrease continuously as it gets closer to the upper surface 120a of the lower wiring capping layer 120. For example, the width W2 of the lower surface of the via 150 in the horizontal direction DR1 may be smaller than the width W3 of the lower wiring capping layer 120 in the horizontal direction DR1. Additionally or alternatively, the width W2 of the lower surface of the via 150 in the horizontal direction DR1 may be smaller than the width W1 of the upper surface of the lower wiring layer 110 in the horizontal direction DR1.

For example, the via 150 may be formed as a single layer. For example, the via 150 may include the same material as the lower wiring capping layer 120. For example, the lower wiring capping layer 120 may include the same material as the via 150 throughout. For example, the via 150 may include molybdenum (Mo). In some other embodiments, the via 150 may alternatively or additionally include manganese (Mn), ruthenium (Ru), carbon nano tube (CNT), and/or graphene. In FIG. 1, the via 150 is shown as being formed in different layers from the lower wiring capping layer 120, but this is for convenience of explanation, and the via 150 and the lower wiring capping layer 120 may be formed integrally. For example, the lower wiring capping layer 120 may be formed integrally with the via 150 throughout.

The third interlayer insulating layer 160 may be disposed on the upper surface 140a of the second interlayer insulating layer 140. The third interlayer insulating layer 160 may be in contact with the upper surface 140a of the second interlayer insulating layer 140. For example, the third interlayer insulating layer 160 may include a different material from the second interlayer insulating layer 140, but the present disclosure is not limited thereto. For example, the third interlayer insulating layer 160 may include at least one of silicon oxide (SiO2), silicon nitride (SiN), silicon oxynitride (SiON), and/or a low-k material

The upper wiring trench T3 may be formed inside of the third interlayer insulating layer 160 on the upper surface of the via 150. The upper wiring trench T3 may be formed to recess or extend toward the inside of the third interlayer insulating layer 160 from the upper surface of the third interlayer insulating layer 160. For example, the sidewalls of the upper wiring trench T3 may be defined by the third interlayer insulating layer 160. Further, the bottom surface of the upper wiring trench T3 may be defined by the upper surface 140a of the second interlayer insulating layer 140. For example, the width of the upper wiring trench T3 in the horizontal direction DR1 may decrease continuously as it gets closer to the upper surface 140a of the second interlayer insulating layer 140.

The upper wiring layer 170 may be disposed inside the upper wiring trench T3. That is, the upper wiring layer 170 may be disposed inside the third interlayer insulating layer 160. For example, the width of the upper wiring layer 170 in the horizontal direction DR1 may decrease continuously as it gets closer to the upper surface 140a of the second interlayer insulating layer 140. For example, the upper surface of the upper wiring layer 170 may be exposed on the upper surface of the third interlayer insulating layer 160. For example, the upper surface of the upper wiring layer 170 may be formed on the same plane as the upper surface of the third interlayer insulating layer 160, but the present disclosure is not limited thereto. For example, the upper wiring layer 170 may include an upper wiring barrier layer 171 and an upper wiring filling layer 172.

The upper wiring barrier layer 171 may be disposed along the sidewalls of the upper wiring trench T3. For example, the upper wiring barrier layer 171 may be conformally formed. The sidewalls of the upper wiring barrier layer 171 disposed inside the upper wiring trench T3 may be in contact with the third interlayer insulating layer 160. The upper wiring barrier layer 171 may be disposed along at least a portion of the bottom surface of the upper wiring trench T3. The lower surface of the upper wiring barrier layer 171 disposed inside the upper wiring trench T3 may be in contact with the upper surface 140a of the second interlayer insulating layer 140.

For example, at least a portion of the upper wiring barrier layer 171 may be disposed inside of the via trench T2. That is, at least a portion of the upper wiring barrier layer 171 may be disposed on the sidewalls of the via trench T2. The sidewalls of the upper wiring barrier layer 171 disposed inside the via trench T2 may be in contact with the second interlayer insulating layer 140. Additionally or alternatively, a lowermost surface of the upper wiring barrier layer 171 disposed inside the via trench T2 may be in contact with the upper surface of the via 150.

For example, the uppermost surface of the upper wiring barrier layer 171 may be exposed on or at the upper surface of the third interlayer insulating layer 160. For example, the uppermost surface of the upper wiring barrier layer 171 may be formed on the same plane as the upper surface of the third interlayer insulating layer 160, but the present disclosure is not limited thereto. The upper wiring barrier layer 171 may include, for example, any one or more of titanium (Ti), titanium nitride (TiN), tantalum (Ta), tantalum nitride (TaN), tantalum carbon nitride (TaCN), tungsten (W), tungsten nitride (WN), tungsten carbonitride (WCN), zirconium (Zr), zirconium nitride (ZrN), vanadium (V), vanadium nitride (VN), niobium (Nb), niobium nitride (NbN), or any combination thereof. However, the present disclosure is not limited thereto.

The upper wiring filling layer 172 may be disposed on the upper wiring barrier layer 171 inside the upper wiring trench T3. The upper wiring filling layer 172 may at least partially fill the inside of the upper wiring trench T3 on the upper wiring barrier layer 171. For example, the upper surface of the upper wiring filling layer 172 may be exposed on the upper surface of the third interlayer insulating layer 160. For example, the upper surface of the upper wiring filling layer 172 may be formed on the same plane as the upper surface of the third interlayer insulating layer 160, but the present disclosure is not limited thereto.

For example, at least a portion of the upper wiring filling layer 172 may be disposed inside the via trench T2. However, the present disclosure is not limited thereto. For example, the upper wiring filling layer 172 may be in contact with the upper surface of the via 150. In other words, the upper wiring barrier layer 171 is not disposed between at least a portion of the upper surface of the via 150 and the upper wiring filling layer 172. The upper wiring filling layer 172 may include, for example, at least one of copper (Cu), carbon (C), silver (Ag), cobalt (Co), tantalum (Ta), indium (In), tin (Sn), zinc (Zn), manganese (Mn), titanium (Ti), magnesium (Mg), chromium (Cr), germanium (Ge), strontium (Sr), platinum (Pt), aluminum (Al), zirconium (Zr), tungsten (W), ruthenium (Ru), iridium (Ir), and/or rhodium (Rh). However, the present disclosure is not limited thereto.

The upper wiring capping layer 180 may be disposed on the upper surface of the upper wiring layer 170. The upper wiring capping layer 180 may be in contact with the upper surface of the upper wiring layer 170. For example, the upper wiring capping layer 180 may be in contact with the uppermost surface of the upper wiring barrier layer 171 and an upper surface of the upper wiring filling layer 172. For example, the upper wiring capping layer 180 may protrude or extend in a vertical direction DR2 further than the upper surface of the third interlayer insulating layer 160 relative to the upper surface of the substrate 100. That is, the upper surface of the upper wiring capping layer 180 may be formed at a higher level in the vertical direction DR2 than the upper surface of the third interlayer insulating layer 160 relative to the upper surface of the substrate 100.

For example, the width of the upper wiring capping layer 180 in the horizontal direction DR1 may be the same as the width of the upper surface of the upper wiring layer 170 in the horizontal direction DR1. In other words, the upper wiring capping layer 180 may be disposed to entirely cover or overlap the upper surface of the upper wiring layer 170 in the vertical direction DR2. For example, the upper wiring capping layer 180 may include different materials from each of the upper wiring barrier layer 171 and the upper wiring filling layer 172. For example, the upper wiring capping layer 180 may include the same materials as each of the lower wiring capping layer 120 and the via 150. For example, the upper wiring capping layer 180 may include molybdenum (Mo). In some other embodiments, the upper wiring capping layer 180 may additionally or alternatively include manganese (Mn), ruthenium (Ru), Carbon Nano Tube (CNT), and/or graphene.

The fourth interlayer insulating layer 190 may be disposed on the upper surface of the third interlayer insulating layer 160, and on the sidewalls and upper surface of the upper wiring capping layer 180. The fourth interlayer insulating layer 190 may be in contact with the upper surface of the third interlayer insulating layer 160, and the sidewalls and upper surface of the upper wiring capping layer 180. For example, the fourth interlayer insulating layer 190 may include at least one of silicon oxide (SiO2), silicon nitride (SiN), silicon oxynitride (SiON), and/or a low-k material.

Hereinafter, with reference to FIG. 1, FIGS. 3 to 9, the method of fabricating a semiconductor device according to some embodiments of the present disclosure will be described.

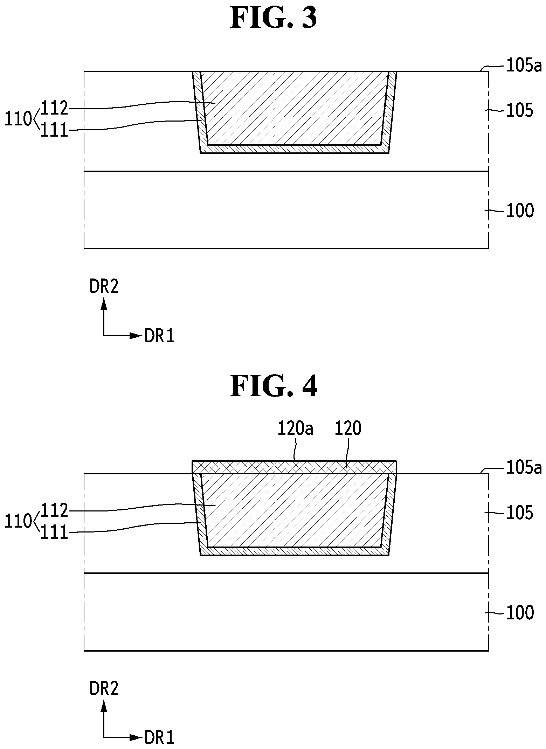

FIGS. 3 to 9 are intermediate stage diagrams for explaining a method of fabricating a semiconductor device according to some embodiments of the present disclosure.

Referring to FIG. 3, the first interlayer insulating layer 105 may be formed on the upper surface of the substrate 100. Subsequently, the lower wiring trench T1 may be formed inside the first interlayer insulating layer 105. The lower wiring trench T1 may be formed to recess or extend from the upper surface of the first interlayer insulating layer 105 toward the inside of the first interlayer insulating layer 105. Subsequently, the lower wiring layer 110 including the lower wiring barrier layer 111 and the lower wiring filling layer 112 may be formed inside the lower wiring trench T1.

For example, the lower wiring barrier layer 111 may be formed on the upper surface 105a of the first interlayer insulating layer 105, and on the sidewalls and the bottom surface of the lower wiring trench T1. Subsequently, the lower wiring filling layer 112 may be formed on the lower wiring barrier layer 111 inside the lower wiring trench T1 and on the upper surface 105a of the first interlayer insulating layer 105. Subsequently, the upper surface 105a of the first interlayer insulating layer 105 may be exposed by performing a planarization process.

Referring to FIG. 4, the lower wiring capping layer 120 may be formed on the upper surface of the lower wiring layer 110. For example, the lower wiring capping layer 120 may entirely cover or overlap the upper surface of the lower wiring layer 110 in the vertical direction DR2. For example, the lower wiring capping layer 120 may protrude or extend in the vertical direction DR2 further than the upper surface 105a of the first interlayer insulating layer 105 relative to the upper surface of the substrate 100. In other words, the upper surface 120a of the lower wiring capping layer 120 may be formed at a higher level in the vertical direction DR2 than the upper surface 105a of the first interlayer insulating layer 105.

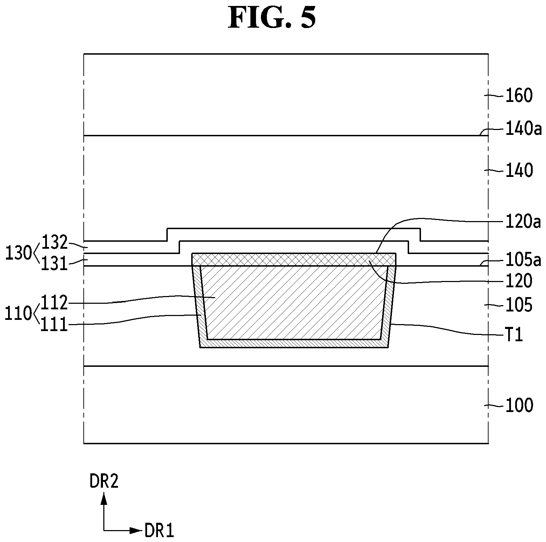

Referring to FIG. 5, the etching stop layer 130 may be formed on the upper surface 105a of the first interlayer insulating layer 105, and on the upper surface 120a and the sidewalls of the lower wiring capping layer 120. The etching stop layer 130 may be in contact with the upper surface 105a of the first interlayer insulating layer 105, upper surface 120a and the sidewalls of the lower wiring capping layer 120. For example, the etching stop layer 130 may include the first etching stop layer 131 and the second etching stop layer 132. The first etching stop layer 131 may be in contact with each of the upper surface 105a of the first interlayer insulating layer 105, the upper surface 120a and the sidewalls of the lower wiring capping layer 120. The second etching stop layer 132 may be disposed on the first etching stop layer 131.

Subsequently, the second interlayer insulating layer 140 may be formed on the upper surface of the etching stop layer 130. That is, the second interlayer insulating layer 140 may be formed on the upper surface of the second etching stop layer 132. Subsequently, the third interlayer insulating layer 160 may be formed on the upper surface 140a of the second interlayer insulating layer 140.

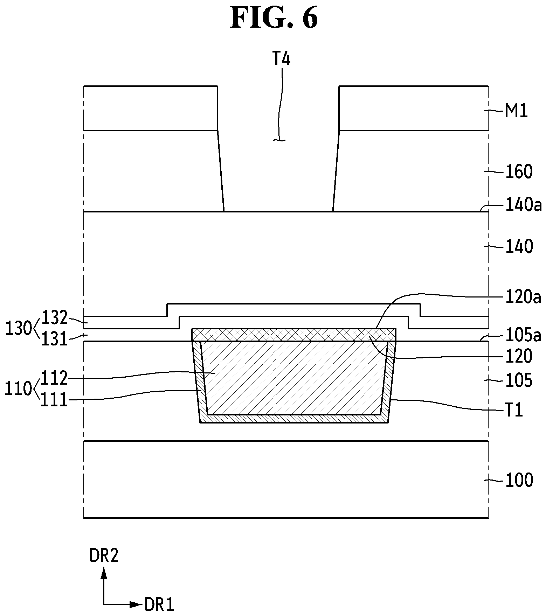

Referring to FIG. 6, a first mask pattern M1 may be formed on the upper surface of the third interlayer insulating layer 160. Subsequently, the third interlayer insulating layer 160 may be etched using the first mask pattern M1 as an etching mask, such that a trench T4 may be formed inside the third interlayer insulating layer 160. For example, the upper surface 140a of the second interlayer insulating layer 140 may be exposed through or by the bottom surface of the trench T4.

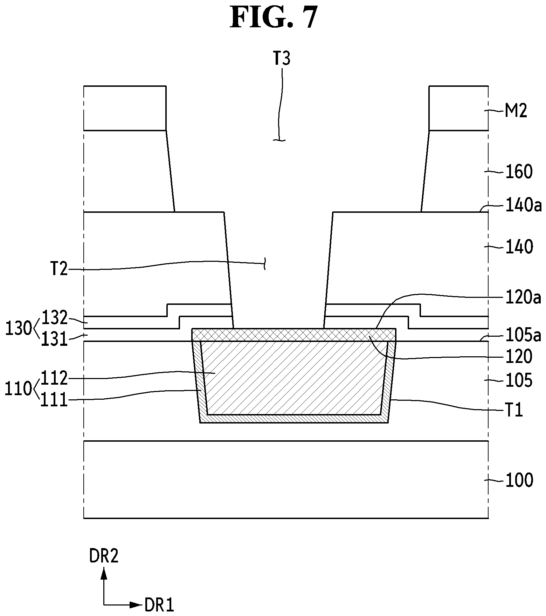

Referring to FIG. 7, the first mask pattern M1 (see FIG. 6) may be removed. Subsequently, a second mask pattern M2 may be formed on the upper surface of the third interlayer insulating layer 160. Subsequently, the third interlayer insulating layer 160, the second interlayer insulating layer 140, and the etching stop layer 130 may be etched using the second mask pattern M2 as an etching mask.

For example, a trench formed by the etching of the second interlayer insulating layer 140 and the etching stop layer 130 may be defined as a via trench T2. The via trench T2 may be formed to recess or extend from the upper surface 140a of the second interlayer insulating layer 140 toward the inside of the second interlayer insulating layer 140. The upper surface 120a of the lower wiring capping layer 120 may be exposed through or by the via trench T2.

Additionally or alternatively, the trench formed by etching the third interlayer insulating layer 160 may be defined as the upper wiring trench T3. The upper wiring trench T3 may be formed to recess or extend from the upper surface of the third interlayer insulating layer 160 toward the inside of the third interlayer insulating layer 160. A portion of the upper surface 140a of the second interlayer insulating layer 140 and the via trench T2 may be exposed by the third interlayer insulating layer 160. For example, the width of the upper wiring trench T3 in the horizontal direction DR1 may be larger than the width of the via trench T2 in the horizontal direction DR1.

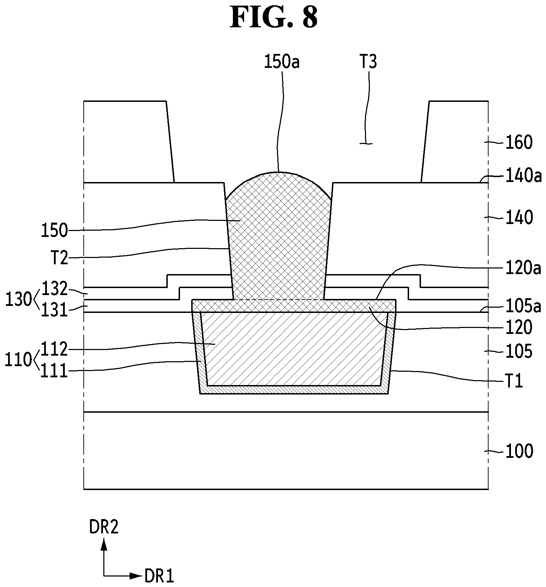

Referring to FIG. 8, the second mask pattern M2 (see FIG. 7) may be removed. Subsequently, the via 150 may be formed inside the via trench T2. For example, the via 150 may at least partially fill the inside of the via trench T2. For example, the upper surface of the via 150 may be formed to be convex. For example, the uppermost surface 150a of the via 150 may be formed at a higher level in the vertical direction DR2 relative to the upper surface of the substrate 100 than the upper surface 140a of the second interlayer insulating layer 140. For example, at least a portion of the upper surface of the via 150 may be formed at a lower level in the vertical direction DR2 relative to the upper surface of the substrate 100 than the upper surface 140a of the second interlayer insulating layer 140. In other words, the sidewalls of the second interlayer insulating layer 140 may be exposed on or at the upper surface of the via 150.

For example, the via 150 may be formed by growing out from the lower wiring capping layer 120. Accordingly, the via 150 may include the same material as the lower wiring capping layer 120. The lower wiring capping layer 120 may include the same material as the via 150 throughout. For example, the via 150 and the lower wiring capping layer 120 may be formed integrally. For example, the lower wiring capping layer 120 may be integrally formed with the via 150 throughout.

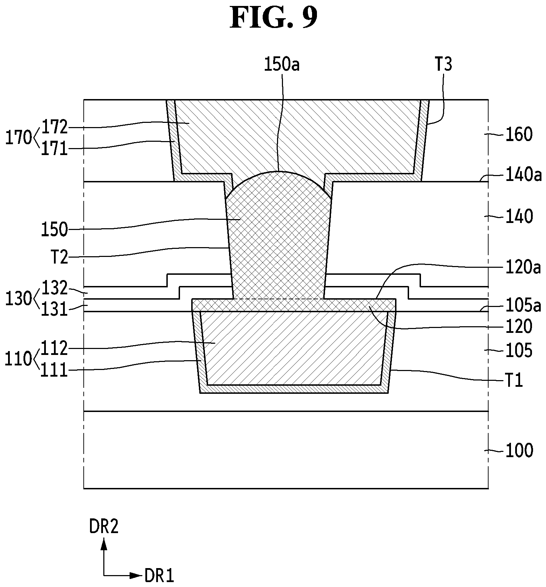

Referring to FIG. 9, the upper wiring layer 170 including the upper wiring barrier layer 171 and the upper wiring filling layer 172 may be formed inside the upper wiring trench T3 on the upper surface of the via 150. For example, the upper wiring barrier layer 171 may be formed along the upper surface of the third interlayer insulating layer 160, and the sidewalls and the bottom surface of the upper wiring trench T3. For example, the upper wiring barrier layer 171 may be formed conformally. For example, the upper wiring barrier layer 171 may also be formed on the sidewalls of the via trench T2 on the upper surface of the via 150. For example, the upper wiring barrier layer 171 may not be formed on at least a portion of the upper surface of the via 150. That is, at least a portion of the upper surface of the via 150 may be exposed between the upper wiring barrier layer 171.

Subsequently, the upper wiring filling layer 172 may be formed to at least partially fill the upper wiring trench T3 on the upper surface of the via 150 and the upper wiring barrier layer 171. For example, the upper wiring filling layer 172 may be in contact with the upper surface of the via 150. For example, the upper wiring filling layer 172 may also be formed on the upper surface of the third interlayer insulating layer 160. Subsequently, the upper surface of the third interlayer insulating layer 160 may be exposed by performing a planarization process.

Referring to FIG. 1, the upper wiring capping layer 180 may be formed on the upper surface of the upper wiring layer 170. For example, the upper wiring capping layer 180 may entirely cover or overlap the upper surface of the upper wiring layer 170 in the vertical direction DR2. For example, the upper wiring capping layer 180 may protrude or extend in the vertical direction DR2 further than the upper surface of the third interlayer insulating layer 160 relative to the upper surface of the substrate 100. In other words, the upper surface of the upper wiring capping layer 180 may be formed at a higher level in the vertical direction DR2 relative to the upper surface of the substrate 100 than the upper surface of the third interlayer insulating layer 160. Subsequently, the fourth interlayer insulating layer 190 may be formed on the upper surface of the third interlayer insulating layer 160, and the sidewalls and upper surface of the upper wiring capping layer 180. Through such a fabricating process, the semiconductor device shown in FIG. 1 may be fabricated.

In the method of fabricating a semiconductor device according to some embodiments of the present disclosure, the via trench T2 in which the via 150 is formed does not penetrate or extend into the lower wiring capping layer 120. That is, through the via trench T2, the sidewalls of the lower wiring capping layer 120 and the upper surface of the lower wiring layer 110 are not exposed. The via 150 may be formed by growing out from the upper surface 120a of the lower wiring capping layer 120 exposed through the via trench T2. Accordingly, the method of fabricating a semiconductor device according to some embodiments of the present disclosure may improve the electrical reliability of the lower wiring layer 110 by preventing or inhibiting the lower wiring capping layer 120 and the lower wiring layer 110 from being etched during the process of forming the via trench T2.

In a semiconductor device according to some embodiments of the present disclosure fabricated by a fabricating method as described above, the via 150 and the lower wiring capping layer 120 may include the same material. For example, in a semiconductor device according to some embodiments of the present disclosure, the lower wiring capping layer 120 may include the same material as the via 150 throughout. Additionally or alternatively, in a semiconductor device according to some embodiments of the present disclosure, at least a portion of the upper surface of the lower wiring capping layer 120 may be in contact with the etching stop layer 130.

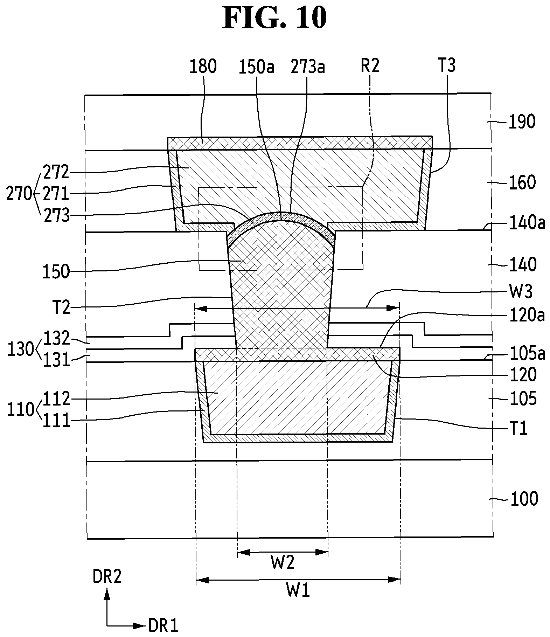

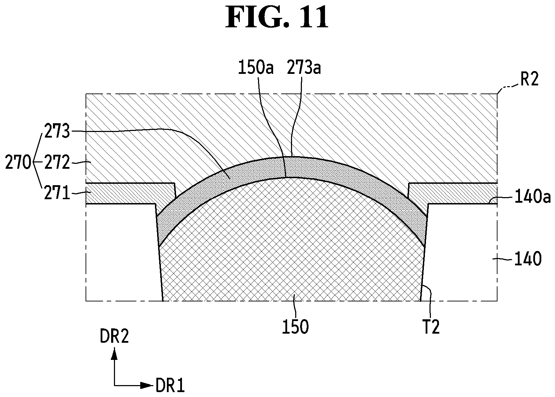

Hereinafter, a semiconductor device according to some other embodiments of the present disclosure will be described with reference to FIGS. 10 and 11. The description will focus on differences from the semiconductor device shown in FIGS. 1 and 2.

FIG. 10 is a diagram for explaining a semiconductor device according to some other embodiments of the present disclosure. FIG. 11 is an enlarged view of the region R2 of FIG. 10.

Referring to FIG. 10 and FIG. 11, in a semiconductor device according to some other embodiments of the present disclosure, the liner layer 273 may be disposed between the upper surface of the via 150 and the upper wiring filling layer 272.

For example, the upper wiring layer 270 may include the upper wiring barrier layer 271, the upper wiring filling layer 272, and the liner layer 273. For example, the liner layer 273 may be disposed between the upper surface of the via 150 and the upper wiring filling layer 272. For example, at least a portion of the liner layer 273 may be disposed inside the via trench T2. For example, the lower surface of the liner layer 273 may be in contact with the upper surface of the via 150. For example, the upper surface 273a of the liner layer 273 may be in contact with the upper wiring filling layer 272. For example, at least a portion of the upper surface 273a of the liner layer 273 may be in contact with the upper wiring barrier layer 271.

For example, the sidewalls of the liner layer 273 may be in contact with the second interlayer insulating layer 140. The liner layer 273 may include metal. For example, the liner layer 273 may include different materials from each of the via 150, the upper wiring barrier layer 271, and the upper wiring filling layer 272. For example, the liner layer 273 may include ruthenium (Ru) or cobalt (Co).

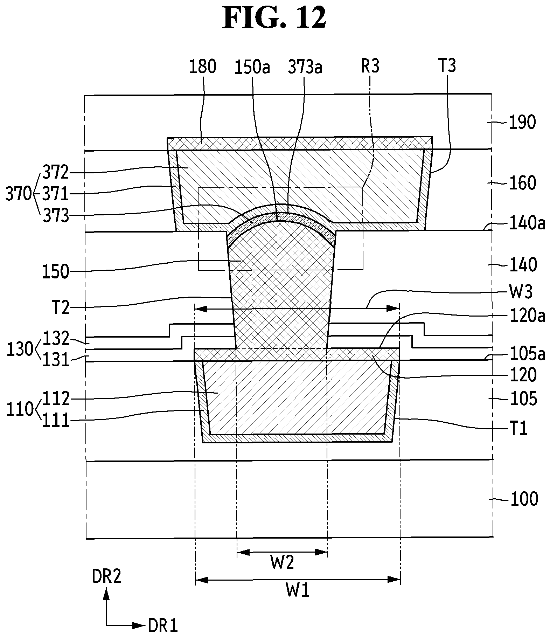

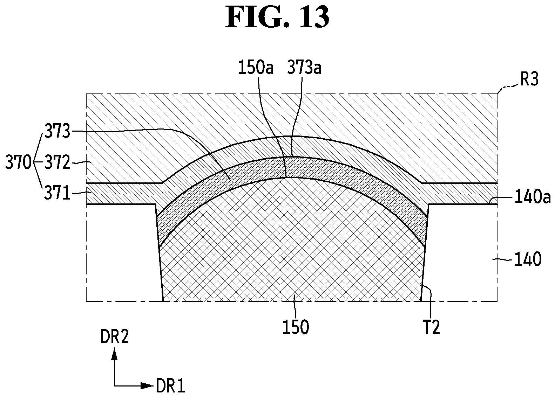

Hereinafter, a semiconductor device according to some other embodiments of the present disclosure will be described with reference to FIGS. 12 and 13. The description will focus on differences from the semiconductor device shown in FIGS. 1 and 2.

FIG. 12 is a diagram for explaining a semiconductor device according to another embodiments of the present disclosure. FIG. 13 is an enlarged view of the region R3 of FIG. 12.

Referring to FIG. 12 and FIG. 13, in a semiconductor device according to embodiments of the present disclosure, the liner layer 373 and the upper wiring barrier layer 371 may be disposed between the upper surface of the via 150 and the upper wiring filling layer 372.

For example, the upper wiring layer 370 may include the upper wiring barrier layer 371, the upper wiring filling layer 372, and the liner layer 373. For example, the liner layer 373 may be disposed between the upper surface of the via 150 and the upper wiring filling layer 372. For example, at least a portion of the liner layer 373 may be disposed inside the via trench T2. For example, a lower surface of the liner layer 373 may be in contact with the upper surface of the via 150. For example, the sidewalls of the liner layer 373 may be in contact with the second interlayer insulating layer 140. The liner layer 373 may include metal. For example, the liner layer 373 may include different materials from each of the via 150, the upper wiring barrier layer 371, and the upper wiring filling layer 372. For example, the liner layer 373 may include ruthenium (Ru) or cobalt (Co).

For example, the upper wiring barrier layer 371 may be disposed between the upper surface of the liner layer 373 and the upper wiring filling layer 372. That is, the liner layer 373 is not in contact with the upper wiring filling layer 372. For example, the upper wiring barrier layer 371 may be in contact with the upper surface of the liner layer 373. For example, at least a portion of the upper wiring barrier layer 371 may be disposed inside the via trench T2. However, the present disclosure is not limited thereto.

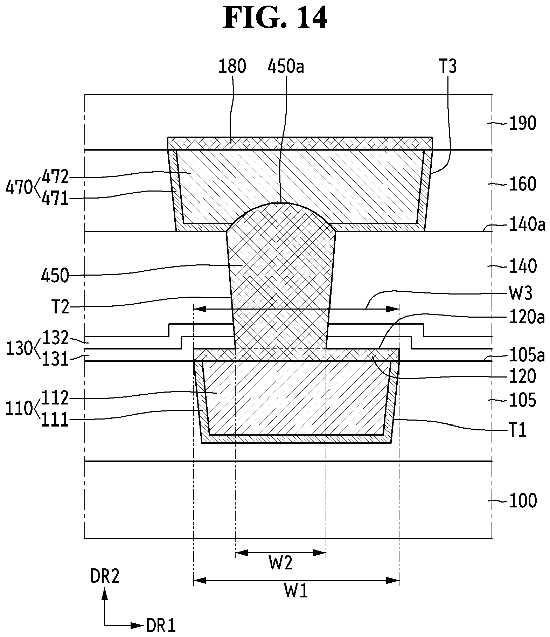

Hereinafter, a semiconductor device according to some other embodiments of the present disclosure will be described with reference to FIG. 14. The description will focus on differences from the semiconductor device shown in FIGS. 1 and 2.

FIG. 14 is a diagram for explaining a semiconductor device according to some other embodiments of the present disclosure.

Referring to FIG. 14, in a semiconductor device according to some other embodiments of the present disclosure, the upper surface of the via 450 may be formed entirely to be at a higher level in the vertical direction DR2 relative to the upper surface of the substrate 100 than the upper surface 140a of the second interlayer insulating layer 140.

For example, the upper wiring layer 470 may include the upper wiring barrier layer 471 and the upper wiring filling layer 472. For example, at least a portion of an upper surface of the via 450 may be in contact with the sidewalls of the upper wiring barrier layer 471 inside the upper wiring trench T3. For example, the uppermost surface 450a of the via 450 may be in contact with the upper wiring filling layer 472 inside the upper wiring trench T3. For example, each of the upper wiring barrier layer 471 and the upper wiring filling layer 472 is not disposed inside the via trench T2.

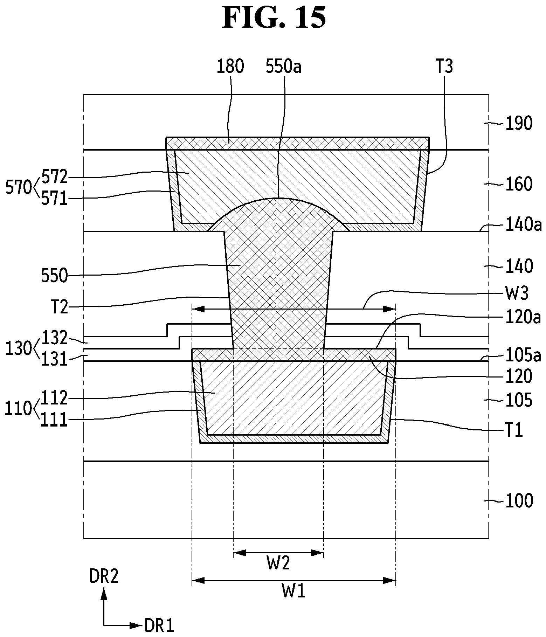

Hereinafter, a semiconductor device according to some other embodiments of the present disclosure will be described with reference to FIG. 15. The description will focus on differences from the semiconductor device shown in FIGS. 1 and 2.

FIG. 15 is a diagram for explaining a semiconductor device according to embodiments of the present disclosure.

Referring to FIG. 15, in a semiconductor device according to some other embodiments of the present disclosure, at least a portion of the via 550 may be in contact with the upper surface 140a of the second interlayer insulating layer 140.

For example, the upper wiring layer 570 may include the upper wiring barrier layer 571 and the upper wiring filling layer 572. For example, at least a portion of the upper surface of the via 550 may be in contact with the sidewalls of the upper wiring barrier layer 571 inside the upper wiring trench T3. For example, the uppermost surface 550a of the via 550 may be in contact with the upper wiring filling layer 572 inside the upper wiring trench T3. For example, each of the upper wiring barrier layer 571 and the upper wiring filling layer 572 is not disposed inside the via trench T2. For example, at least a portion of the via 550 may protrude or extend in the lateral direction beyond the sidewalls of the via trench T2. For example, the portion of the via 550 that protrudes or extends in the lateral direction beyond the sidewalls of the via trench T2 may be in contact with the upper surface 140a of the second interlayer insulating layer 140.

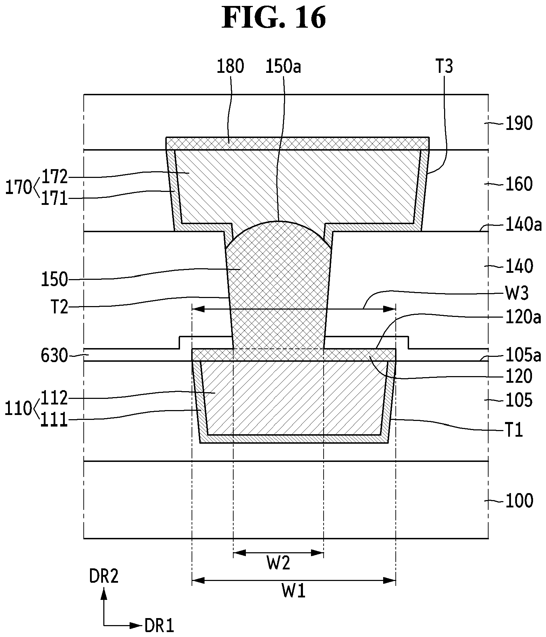

Hereinafter, a semiconductor device according to some other embodiments of the present disclosure will be described with reference to FIG. 16. The description will focus on differences from the semiconductor device shown in FIGS. 1 and 2.

FIG. 16 is a diagram for explaining a semiconductor device according to another several embodiments of the present disclosure.

Referring to FIG. 16, in a semiconductor device according to some embodiments of the present disclosure, the etching stop layer 630 may be formed as a single layer.

For example, the etching stop layer 630 may be formed as a single layer between the upper surface 105a of the first interlayer insulating layer 105 and the second interlayer insulating layer 140. In addition, the etching stop layer 630 may be formed as a single layer between the lower wiring capping layer 120 and the second interlayer insulating layer 140. For example, the etching stop layer 630 may include different materials from each of the first interlayer insulating layer 105, the second interlayer insulating layer 140, and the lower wiring capping layer 120. For example, it may include any one or more of aluminum oxide (Al2O3), aluminum nitride (AlN), hafnium oxide (Hf2O3), zirconium oxide (Zr2O3), silicon oxycarbide (SiOC), silicon carbide (SiC), and/or silicon oxide (SiO2).

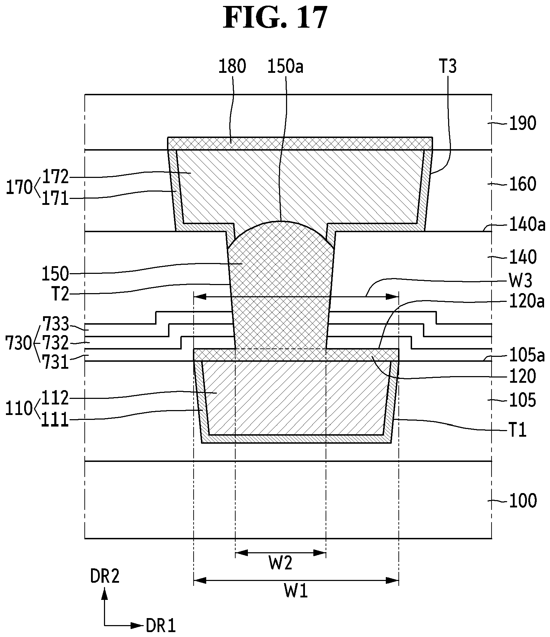

Hereinafter, a semiconductor device according to some other embodiments of the present disclosure will be described with reference to FIG. 17. The description will focus on differences from the semiconductor device shown in FIGS. 1 and 2.

FIG. 17 is a diagram for explaining a semiconductor device according to embodiments of the present disclosure.

Referring to FIG. 17, in a semiconductor device according to embodiments of the present disclosure, the etching stop layer 730 may be formed to have three layers.

For example, the etching stop layer 730 may include the first etching stop layer 731, the second etching stop layer 732, and the third etching stop layer 733. For example, the first etching stop layer 731 may be in contact with the upper surface 105a of the first interlayer insulating layer 105, the upper surface 120a and the sidewalls of the lower wiring capping layer 120. For example, the first etching stop layer 731 may be formed conformally. The second etching stop layer 732 may be disposed on the first etching stop layer 731. The second etching stop layer 732 may be disposed along the surface of the first etching stop layer 731. The second etching stop layer 732 may be in contact with the first etching stop layer 731. For example, the second etching stop layer 732 may be conformally formed. The third etching stop layer 733 may be disposed on the second etching stop layer 732. The third etching stop layer 733 may be disposed along the surface of the second etching stop layer 732. The third etching stop layer 733 may be in contact with the second etching stop layer 732. For example, the third etching stop layer 733 may be conformally formed.

For example, the first etching stop layer 731 may include aluminum oxide (Al2O3), aluminum nitride (AlN), hafnium oxide (Hf2O3), or zirconium oxide (Zr2O3). For example, the second etching stop layer 732 may include a different material from the first etching stop layer 731. For example, the second etching stop layer 732 may include any one or more of silicon oxycarbide (SiOC), silicon carbide (SiC), and/or silicon oxide (SiO2). For example, the third etching stop layer 733 may include a different material from the second etching stop layer 732. For example, the third etching stop layer 733 may include aluminum oxide (Al2O3), aluminum nitride (AlN), hafnium oxide (Hf2O3), or zirconium oxide (Zr2O3). For example, the third etching stop layer 733 may include the same material as the first etching stop layer 731, but the present disclosure is not limited thereto. In some other embodiments, the third etching stop layer 733 may include a different material from the first etching stop layer 731.

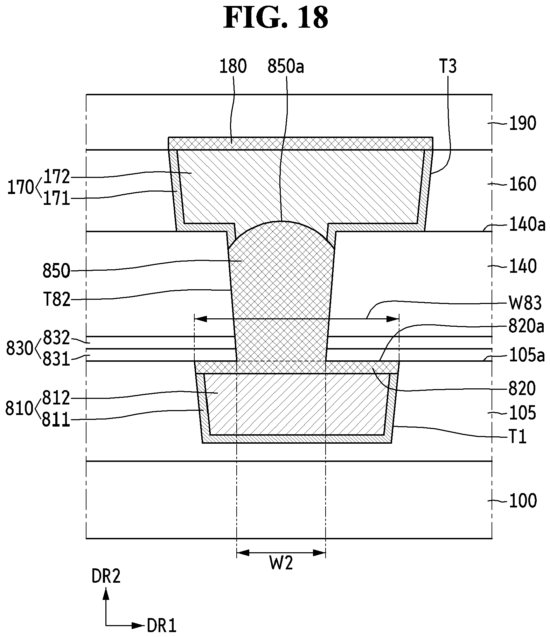

Hereinafter, a semiconductor device according to some other embodiments of the disclosure will be described with reference to FIG. 18. The description will focus on differences from the semiconductor device shown in FIGS. 1 and 2.

FIG. 18 is a diagram for explaining a semiconductor device according to yet some other embodiments of the present disclosure.

Referring to FIG. 18, in a semiconductor device according to embodiments of the present disclosure, the lower wiring capping layer 820 may be disposed inside the lower wiring trench T1.

For example, the lower wiring layer 810 may include a lower wiring barrier layer 811 and a lower wiring filling layer 812. The lower wiring barrier layer 811 may be disposed along the sidewalls and bottom surface of the lower wiring trench T1. For example, the uppermost surface of the lower wiring trench T1 may be formed to be at a lower level in the vertical direction DR2 relative to the upper surface of the substrate 100 than the upper surface 105a of the first interlayer insulating layer 105. The lower wiring filling layer 812 may at least partially fill a portion of the lower wiring trench T1 on the lower wiring barrier layer 811. For example, the upper surface of the lower wiring filling layer 812 may be formed to be at a lower level in the vertical direction DR2 relative to the upper surface of the substrate 100 than the upper surface 105a of the first interlayer insulating layer 105.

For example, the lower wiring capping layer 820 may at least partially fill the remaining portion of the lower wiring trench T1 on the uppermost surface of the lower wiring barrier layer 811 and the upper surface of the lower wiring filling layer 812. For example, the upper surface of the lower wiring capping layer 820 may be formed on the same plane as the upper surface 105a of the first interlayer insulating layer 105 (e.g., the upper surface of the lower wiring capping layer 820 and the upper surface 105a are coplanar). For example, the sidewalls of the lower wiring capping layer 820 may be in contact with the first interlayer insulating layer 105. For example, the width W83 of the lower wiring capping layer 820 in the horizontal direction DR1 may be larger than the width W2 of the lower surface of the via 850 in the horizontal direction DR1.

The etching stop layer 830 may be disposed on each of an upper surface 820a of the lower wiring capping layer 820 and the upper surface 105a of the first interlayer insulating layer 105. For example, the etching stop layer 830 may be in contact with each of the upper surface 820a of the lower wiring capping layer 820 and the upper surface 105a of the first interlayer insulating layer 105. For example, the etching stop layer 830 may include the first etching stop layer 831 and the second etching stop layer 832. The first etching stop layer 831 may be in contact with the upper surface 105a of the first interlayer insulating layer 105 and the upper surface 820a of the lower wiring capping layer 820. The second etching stop layer 832 may be in contact with the upper surface of the first etching stop layer 831.

The via trench T82 may penetrate or extend into the etching stop layer 830 and the second interlayer insulating layer 140 in the vertical direction DR2. The via trench T82 may extend to the upper surface 820a of the lower wiring capping layer 820. For example, the bottom surface of the via trench T82 may be formed on the same plane as or to be coplanar with the lowermost surface of the etching stop layer 830. The via 850 may be disposed inside the via trench T82. For example, the lower surface of the via 850 may be formed on the same plane as or to be coplanar with the lowermost surface of the etching stop layer 830. For example, the uppermost surface 850a of the via 850 may be formed at a higher level in the vertical direction DR2 relative to the upper surface of the substrate 100 than the upper surface 140a of the second interlayer insulating layer 140.

Additionally or alternatively to optional features discussed above, in a semiconductor device or method of fabricating any semiconductor device according to any embodiment of the present disclosure, the via trench T2 in which the via 150 is formed may not penetrate the lower wiring capping layer 120. Walls, such as the sidewalls, of the lower wiring capping layer 120 and the upper surface of the lower wiring layer 110 may not be exposed through the via trench T2. It is further noted that the via 150 may be formed by growing from the upper surface 120a of the lower wiring capping layer 120 exposed through the via trench T2. As a result of such feature(s), the electrical reliability of the lower wiring layer 110 may be improved. In embodiments, such improved reliability may be achieved by the method preventing the lower wiring capping layer 120 and the lower wiring layer 110 from being etched during the process of forming the via trench T2.

Further additionally or alternatively to optional features as discussed above, in any semiconductor device or fabrication method embodiment of the present disclosure, the via 150 and the lower wiring capping layer 120 may include the same material. For example, the lower wiring capping layer 120 may include the same material as the via 150 throughout. We also note that at least a portion of the upper surface of the lower wiring capping layer 120 may be in contact with the etch stop layer 130.

Embodiments are set out in the following clauses 1 - 3 and A1 - A15:
Clause 1. A semiconductor device comprising:
   a substrate;
   a first interlayer insulating layer on an upper surface of the substrate;
   a lower wiring layer in the first interlayer insulating layer;
   a lower wiring capping layer on an upper surface of the lower wiring layer;
   a second interlayer insulating layer on each of an upper surface of the first interlayer insulating layer and an upper surface of the lower wiring capping layer;
   a via trench that extends into the second interlayer insulating layer in a first direction that is perpendicular to the upper surface of the substrate, wherein the via trench extends to the upper surface of the lower wiring capping layer;
   a via in the via trench, wherein the via is in contact with the upper surface of the lower wiring capping layer, wherein an upper surface of the via in the first direction relative to the upper surface of the substrate is higher than an upper surface of the second interlayer insulating layer in the first direction relative to the upper surface of the substrate;
   a third interlayer insulating layer on the upper surface of the second interlayer insulating layer;
   an upper wiring trench that is in the third interlayer insulating layer and is on the upper surface of the via; and
   an upper wiring layer in contact with the upper surface of the via, wherein the upper wiring layer comprises an upper wiring barrier layer on at least a portion of a lower surface of the upper wiring trench and a sidewall of the upper wiring trench, wherein the upper wiring layer comprises an upper wiring filling layer on the upper wiring barrier layer,
   wherein the lower wiring capping layer comprises a same material as the via.
Clause 2. The semiconductor device of clause 1, further comprising:
   an upper wiring capping layer on an upper surface of the upper wiring layer, wherein the upper wiring capping layer comprises the same material as each of the lower wiring capping layer and the via.
Clause 3. The semiconductor device of clause 1 or 2, wherein at least a portion of the via is in contact with the upper surface of the second interlayer insulating layer.
Clause A1. A semiconductor device comprising:
   a substrate;
   a first interlayer insulating layer disposed on an upper surface of the substrate;
   a lower wiring layer disposed inside the first interlayer insulating layer;
   a lower wiring capping layer disposed on an upper surface of the lower wiring layer;
   an etching stop layer disposed on each of an upper surface of the first interlayer insulating layer and an upper surface of the lower wiring capping layer, the etching stop layer being in contact with the upper surface of the lower wiring capping layer;
   a second interlayer insulating layer disposed on an upper surface of the etching stop layer;
   a via trench penetrating through the etching stop layer and the second interlayer insulating layer in a vertical direction, the via trench extending to the upper surface of the lower wiring capping layer; and
   a via disposed inside the via trench, the via being in contact with the upper surface of the lower wiring capping layer, an uppermost surface of the via formed higher than an upper surface of the second interlayer insulating layer,
   wherein the lower wiring capping layer comprises the same material as the via throughout.
Clause A2. The semiconductor device of clause A1, wherein a width of the lower wiring capping layer in the horizontal direction is the same as a width of the upper surface of the lower wiring layer in the horizontal direction.
Clause A3. The semiconductor device of clause A1 or A2, wherein the via is formed as a single layer, and a sidewall of the via is in contact with each of the etching stop layer and the second interlayer insulating layer.
Clause A4. The semiconductor device of any one of clauses A1 to A3, further comprising:
   a third interlayer insulating layer disposed on the upper surface of the second interlayer insulating layer;
   an upper wiring trench formed inside the third interlayer insulating layer on an upper surface of the via; and
   an upper wiring layer being in contact with the upper surface of the via, the upper wiring layer comprising an upper wiring barrier layer disposed along at least a portion of a lower surface and a sidewall of the upper wiring trench, and an upper wiring filling layer filling an inside of the upper wiring trench on the upper wiring barrier layer.
Clause A5. The semiconductor device of clause A4, wherein the upper wiring filling layer is in contact with the upper surface of the via.
Clause A6. The semiconductor device of clause A4 or A5, wherein the upper wiring layer further comprises a liner layer disposed between the upper surface of the via and the upper wiring filling layer.
Clause A7. The semiconductor device of any one of clauses A1 to A6, wherein the upper surface of the lower wiring capping layer is formed higher than the upper surface of the first interlayer insulating layer, and
   wherein a sidewall of the lower wiring capping layer is in contact with the etching stop layer.
Clause A8. The semiconductor device of any one of clauses A1 to A7, wherein the upper surface of the lower wiring capping layer is formed on the same plane as the upper surface of the first interlayer insulating layer.
Clause A9. The semiconductor device of any one of clauses A1 to A8, wherein the etching stop layer comprises a first etching stop layer and a second etching stop layer, the first etching stop layer is in contact with each of the upper surface of the first interlayer insulating layer and the lower wiring capping layer, the second etching stop layer is disposed between an upper surface of the first etching stop layer and the second interlayer insulating layer, and the second etching stop layer comprises a different material from the first etching stop layer.
Clause A10. The semiconductor device of clause A9, wherein the etching stop layer further comprises a third etching stop layer disposed between an upper surface of the second etching stop layer and the second interlayer insulating layer, and the third etching stop layer comprises a different material from the second etching stop layer.
Clause A11. The semiconductor device of any one of clauses A1 to A10, wherein an upper surface of the via is formed entirely higher than the upper surface of the second interlayer insulating layer.
Clause A12. The semiconductor device of any one of clauses A1 to A11, wherein the lower wiring capping layer and the via comprise molybdenum (Mo).
Clause A13. A semiconductor device, optionally according to any one of preceding clauses A1 to A12, comprising:
   a substrate;
   a first interlayer insulating layer disposed on an upper surface of the substrate;
   a lower wiring layer disposed inside the first interlayer insulating layer;
   a lower wiring capping layer disposed on an upper surface of the lower wiring layer;
   a second interlayer insulating layer disposed on each of an upper surface of the first interlayer insulating layer and an upper surface of the lower wiring capping layer;
   a via trench penetrating through the second interlayer insulating layer in a vertical direction, the via trench extending to the upper surface of the lower wiring capping layer;
   a via disposed inside the via trench, the via being in contact with the upper surface of the lower wiring capping layer, an uppermost surface of the via formed higher than an upper surface of the second interlayer insulating layer;
   a third interlayer insulating layer disposed on the upper surface of the second interlayer insulating layer;
   an upper wiring trench formed inside the third interlayer insulating layer on an upper surface of the via; and
   an upper wiring layer being in contact with the upper surface of the via, the upper wiring layer comprising an upper wiring barrier layer disposed along at least a portion of a lower surface and a sidewall of the upper wiring trench, and an upper wiring filling layer filling an inside of the upper wiring trench on the upper wiring barrier layer,
   wherein the lower wiring capping layer comprises the same material as the via throughout.
Clause A14. The semiconductor device of clause A13, further comprising:
   an upper wiring capping layer disposed on an upper surface of the upper wiring layer, the upper wiring capping layer comprising the same material as each of the lower wiring capping layer and the via.
Clause A15. The semiconductor device of clause A13 or A14, wherein at least a portion of the via is in contact with the upper surface of the second interlayer insulating layer.

While embodiments according to the present disclosure have been described above with reference to the accompanying drawings, it will be understood that the present disclosure is not limited to the above embodiments and may be fabricated in a variety of different forms, and those skilled in the art to which the present disclosure belongs, with ordinary knowledge in the field, may recognize that it can be implemented in other specific forms without changing the technical idea or essential features of the present disclosure. Therefore, it should be understood that the above-described embodiments are in all respects examples and not restrictive.

## Claims

1. A semiconductor device comprising:
a substrate;
a first interlayer insulating layer on an upper surface of the substrate;
a lower wiring layer in the first interlayer insulating layer;
a lower wiring capping layer on an upper surface of the lower wiring layer;
an etching stop layer on each of an upper surface of the first interlayer insulating layer and an upper surface of the lower wiring capping layer, wherein the etching stop layer is in contact with the upper surface of the lower wiring capping layer;
a second interlayer insulating layer on an upper surface of the etching stop layer;
a via trench that extends into the etching stop layer and the second interlayer insulating layer in a first direction that is perpendicular to the upper surface of the substrate, wherein the via trench extends to the upper surface of the lower wiring capping layer; and
a via in the via trench, wherein the via is in contact with the upper surface of the lower wiring capping layer, wherein an upper surface of the via in the first direction relative to the upper surface of the substrate is higher than an upper surface of the second interlayer insulating layer in the first direction relative to the upper surface of the substrate, and
wherein the lower wiring capping layer comprises a same material as the via.

2. The semiconductor device of claim 1, wherein a width of the lower wiring capping layer in a second direction that is parallel to the upper surface of the substrate is equal to a width of the upper surface of the lower wiring layer in the second direction.

3. The semiconductor device of claim 1 or 2, wherein the via comprises a single layer, and a sidewall of the via is in contact with each of the etching stop layer and the second interlayer insulating layer.

4. The semiconductor device of any one of claims 1 to 3, further comprising:
a third interlayer insulating layer on the upper surface of the second interlayer insulating layer;
an upper wiring trench that is in the third interlayer insulating layer and is on the upper surface of the via; and
an upper wiring layer that is in contact with the upper surface of the via, wherein the upper wiring layer comprises an upper wiring barrier layer on at least a portion of a lower surface of the upper wiring trench and a sidewall of the upper wiring trench, and wherein the upper wiring layer comprises an upper wiring filling layer on the upper wiring barrier layer.

5. The semiconductor device of claim 4, wherein the upper wiring filling layer is in contact with the upper surface of the via.

6. The semiconductor device of claim 4 or 5, wherein the upper wiring layer further comprises a liner layer between the upper surface of the via and the upper wiring filling layer.

7. The semiconductor device of any one of claims 1 to 6, wherein:
the upper surface of the lower wiring capping layer in the first direction relative to the upper surface of the substrate is higher than the upper surface of the first interlayer insulating layer in the first direction relative to the upper surface of the substrate, and
a sidewall of the lower wiring capping layer is in contact with the etching stop layer.

8. The semiconductor device of any one of claims 1 to 7, wherein the upper surface of the lower wiring capping layer and the upper surface of the first interlayer insulating layer are coplanar.

9. The semiconductor device of any one of claims 1 to 8, wherein:
the etching stop layer comprises a first etching stop layer and a second etching stop layer,
the first etching stop layer is in contact with each of the upper surface of the first interlayer insulating layer and the lower wiring capping layer, and
wherein the second etching stop layer and the first etching stop layer comprise respective materials that are different from one another.

10. The semiconductor device of claim 9, wherein:
the etching stop layer further comprises a third etching stop layer between an upper surface of the second etching stop layer and the second interlayer insulating layer, and
the third etching stop layer comprises a respective material that is different from the respective materials of the second etching stop layer and the first etching stop layer.

11. The semiconductor device of any one of claims 1 to 10, wherein an entirety of the upper surface of the via in the first direction relative to the upper surface of the substrate is higher than the upper surface of the second interlayer insulating layer in the first direction relative to the upper surface of the substrate.

12. The semiconductor device of any one of claims 1 to 11, wherein the lower wiring capping layer and the via comprise molybdenum (Mo).

13. A semiconductor device according to any preceding claim, comprising:
a substrate;
a first interlayer insulating layer on an upper surface of the substrate;
a lower wiring layer in the first interlayer insulating layer;
a lower wiring capping layer on an upper surface of the lower wiring layer;
a second interlayer insulating layer on each of an upper surface of the first interlayer insulating layer and an upper surface of the lower wiring capping layer;
a via trench that extends into the second interlayer insulating layer in a first direction that is perpendicular to the upper surface of the substrate, wherein the via trench extends to the upper surface of the lower wiring capping layer;
a via in the via trench, wherein the via is in contact with the upper surface of the lower wiring capping layer, wherein an upper surface of the via in the first direction relative to the upper surface of the substrate is higher than an upper surface of the second interlayer insulating layer in the first direction relative to the upper surface of the substrate;
a third interlayer insulating layer on the upper surface of the second interlayer insulating layer;
an upper wiring trench that is in the third interlayer insulating layer and is on the upper surface of the via; and
an upper wiring layer in contact with the upper surface of the via, wherein the upper wiring layer comprises an upper wiring barrier layer on at least a portion of a lower surface of the upper wiring trench and a sidewall of the upper wiring trench, wherein the upper wiring layer comprises an upper wiring filling layer on the upper wiring barrier layer,
wherein the lower wiring capping layer comprises a same material as the via.

14. The semiconductor device of claim 13, further comprising:
an upper wiring capping layer on an upper surface of the upper wiring layer, wherein the upper wiring capping layer comprises the same material as each of the lower wiring capping layer and the via.

15. The semiconductor device of claim 13 or 14, wherein at least a portion of the via is in contact with the upper surface of the second interlayer insulating layer.
